# EUROPEAN PATENT APPLICATION

(11) **EP 4 398 109 A1**
(43) Date of publication of application: **10.07.2024**
(21) Application number: 23215920.2
(22) Date of filing: 11.12.2023
(51) Int. Cl.: G06F 11/36, G06F 11/22, G06F 11/273, G06F 9/46

(54) **TECHNIQUES FOR DEBUG, SURVIVABILITY, AND INFIELD TESTING OF A SYSTEM-ON-A-CHIP OR A SYSTEM-ON-A-PACKAGE**

(30) Priority: 29.12.2022 US 202218091060
(62) Divisional of application: 23215500.2
(71) Applicant: Intel Corporation, Santa Clara, CA 95054 (US)
(72) Inventor: Kandula, Rakesh, Bangalore (IN); Brazil, Edward, Leixlip KE Naas IRL (IL); Zaltzman, Amir, 4463713 Kfar Saba (IL); Peretz, Alon, Haifa (IL); Serebryanik, Alexander, 28000 Kiryat Ata HA (IL); Ziv, Chai, 7958500 Even Shemuel (IL); Baruch, Nir, 6941242 Tel Aviv (IL); Shayevitz, Gilad, Olesh, 4825500 (IL)
(74) Representative: Samson & Partner Patentanwälte mbB

(57) **Abstract**

Examples include techniques for debug, survivability, and infield testing of a system-on-a-chip (SoC) or system-on-a-package (SoP) that can be configured as a processor. The techniques include using an agent coupled with a network-on-chip (NoC) fabric to launch transaction over the NoC fabric to test or debug agents, devices, or devices coupled to the SoC or SoP and/or interconnected to the NoC fabric.

## Description

### TECHNICAL FIELD

Examples described herein are generally related to techniques for debug, survivability, and infield testing of a system-on-a-chip or a system-on-a-package using an agent coupled with a network-on-chip fabric.

### BACKGROUND OF THE INVENTION

A system-on-a-chip or system-on-chip ("SoC") is a term often used to describe a device or system having a processor and associated circuitry (e.g., I/O circuitry, processing cores, power delivery circuitry, memory controller circuitry, memory circuitry, etc.) integrated om a single integrated circuit ("IC") die, chip or substrate. For example, a device, computing platform or computing system could have one or more one or more processor cores and associated circuitry (e.g., I/O circuitry, power delivery circuitry, memory controller circuitry, memory circuitry, etc.) arranged in a disaggregated collection of discrete dies, tiles and/or chiplets (e.g., one or more discrete processor core die arranged adjacent to one or more other die such as memory die, I/O die, etc.). In such disaggregated devices and systems the various dies, tiles and/or chiplets could be physically and electrically coupled together by a package structure including, for example, various packaging substrates, interposers, interconnect bridges and the like. Also, these disaggregated devices can be referred to as a system-on-a-package (SoP). An SoC or SoP, in some implementations can also generally be referred to as a processor

In order to reduce time to market (TTM) for SoCs or SoPs (e.g., configured as processors), silicon bring up times need to be minimized. Hangs, debugs, wrong fuse programming or where a particular agent or device on an SoC is not responding add to silicon bring up times and hence impact TTM. Delays in silicon bring up could result in an SoC manufacturer/designer to lose business opportunities.

### BRIEF DESCRIPTION OF THE DRAWINGS

**FIG. 1** illustrates an example processor.
**FIG. 2** illustrates an example network-on-chip (NoC) ubiquitous agent (UBA) for the Processor.
**FIG. 3** illustrates example first transactions associated with the NoC UBA.
**FIG. 4** illustrates an example loop back scheme.
**FIG. 5** illustrates example second transactions associated with the NoC UBA.
**FIG. 6** illustrates example third transactions associated with the NoC UBA.
**FIG. 7** illustrates an example trigger scheme.
**FIG. 8** illustrates an example first logic flow.

### DETAILED DESCRIPTION

A type of system fabric used to enable various disaggregated devices included in an SoC or an SoP (e.g., configured as a processor) is often referred to as a network-on-chip (NoC) fabric. This NoC fabric is also a type of system fabric that is being used or planned to be used by several different SoC/SoP manufacturers/designers. For example, Intel^{®} Corporation is replacing its Intel on Chip Scalable Fabric (IOSF) with NoC fabric for SoCs/SoPs configured as processors. Other SoC/SoP/processor manufacturers/designers will likely also replace proprietary-based system fabrics for SoCs/SoPs/processors with NoC fabric. Debug agents used for proprietary-based system such as Intel's IOSF are likely to not be compatible and/or having less than desired debugging capabilities for use with NoC fabrics.

In addition to legacy debug agents lacking compatibility with NoC fabrics, current infield scans lack an ability to screen for defects on boundary pins between an SoC/SoP configured as a processor and a connected external device during infield operation of a processor. For example, defects between a Peripheral Component Interconnect Express (PCIe) controller and an external graphics card. Catching such defects during infield operation is important to servers and cloud computing processors because these types of processor deployments have infrequent power downs and power ups and infield scans can require an entire processor to be in an idle state that cannot be found in these types of processor deployments.

Also, legacy debug agents for SoC/SoP system fabrics, such as test access port (TAP) to sideband bridges, use a TAP interface to debug on the sideband bus. The sideband bus is mainly used for firmware (FW) transactions, not for system bus transactions such as transactions that typically pass through an NoC fabric. Use of only the sideband bus can be a major drawback in bringing up an SoC/SoP system fabric such as an NoC fabric and to bringing up agents attached to the SoC/SoP system fabric.

Some debug solutions can lack an ability to generate traffic or inject an active transaction on a system fabric for an SoC/SoP such as an NoC fabric. These debug solutions can collect various silicon information to process using debug tools such as a Lauterbach debugger tool. However, these debug solutions typically cannot actively generate a transaction to mimic other devices coupled to an NoC fabric. For example, to address a hang caused by a controller such as a Universal Serial Bus (USB) controller that has failed to send an interrupt due to incorrect/defective programming by a basic input/output system (BIOS) or an operating system (OS) in the interrupt registers in the configuration space of the controller. These debug solutions will need a system reboot and then run fixed BIOS/OS code to overcome the hang.

Other debug solutions lack an ability to generate various virtualization transactions for an SoC/SoP system fabric such as an NoC fabric. These various virtualization transaction can include translation requests, translated requests, untranslated requests, page request service, coherent transactions, etc. Generation of these various virtualization transactions is needed to correct or identify possible bugs or avoid hangs associated with the various virtualization transactions.

As described in this disclosure, techniques and examples are provided in relation to an NoC ubiquitous debug agent (UBA). The NoC UBA can be configured to be an all type transaction generator agent that can reach all the corners of an SoC or SoP(e.g., configured as a processor). The NoC UBA can also be configured to mimic or imitate any other functional agent or device coupled with an NoC fabric as if the transaction is sent by the functional agent or device. The NoC UBA can also be configured to be used as an automated test equipment (ATE) high volume manufacturing/ (HVM) functional test agent. As an ATE/HVM functional test agent, the NoC UBA can use functional aware protocol patterns to improve @ speed coverage at communication interfaces and stuck@ coverage at a digital to analog boundary of an SoC or a SoP controller and/or at an SoC/SoP boundary associated with the SoC or SoP controller connecting to an external device.

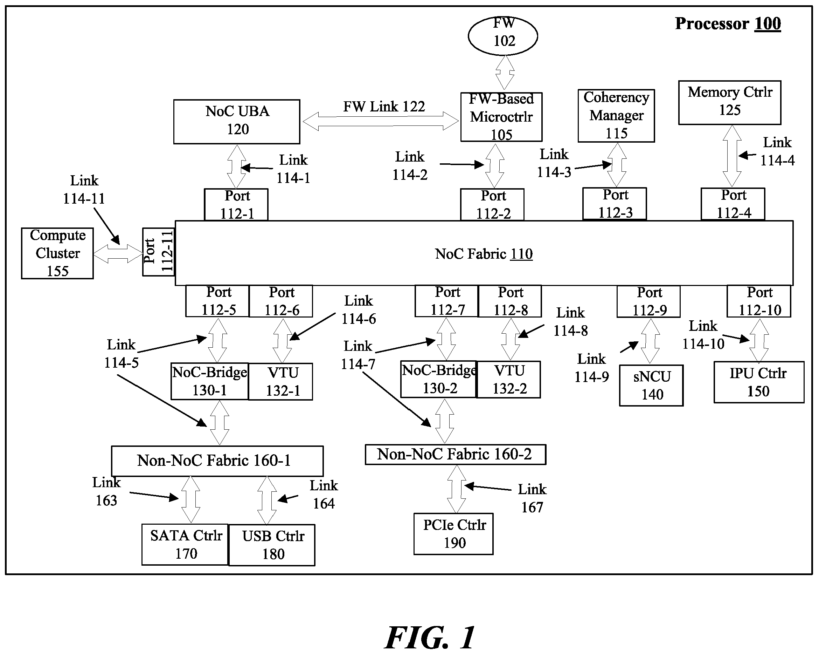

**FIG. 1** illustrates an example processor 100. According to some examples, processor 100 can be an SoC or SoP configured to function as a processor. As shown in FIG. 1, processor 100 includes a NoC fabric 110 having a plurality of access ports 112-1 to 112-11 (examples are not limited to 11 access ports) to couple or connect with various agents or devices via respective links 114-1 to 114-11. For these examples, the various agents or devices include, but are not limited to, a firmware-based (FW-based) microcontroller 105, a coherency manager 115, an NoC UBA 120, NoC-Bridges 130-1 and 130-2, virtual translation units (VTUs) 132-1 and 132-2, a storage network controller unit (sNCU) 140, an image processing unit (IPU) controller 150, or a compute cluster 155. Also, for these examples, links 114-1 to 114-11 and ports 112-1 to 112-11 can be configured to use various coherent or non-coherent protocols to communicate via or over NoC fabric 110. The various coherent or non-coherent protocols can include, but are not limited to, protocols described in the Compute Express Link (CXL) 3.0 specification, published in August of 2022 by the CXL^{™} organization ("the CXL specification") such as CXL.mem, CXL.cache or CXL.io protocols.

According to some examples, as shown in FIG. 1, firmware (FW) 102 can include executable code to be executed by FW-based microcontroller 105. FW 102 can enable a dynamic reprogramming or triggering of types of synthetic content execution by NoC UBA 120. For these examples, FW-based microcontroller 105, responsive to executable code included in FW 102 (e.g., Pcode), can access configuration registers included in NoC UBA 120 via a FW link 122 to initiate the dynamic reprogramming or triggering of types of synthetic content execution by NoC UBA 120. Also, a re-program and re-run of NoC UBA 120 just before or after a specific power management scenario or other point of stress/marginality can be used for survivability/debug/validation purposes.

In some examples, as shown in FIG. 1, processor 100 includes a non-NoC fabric 160-1 and a non-NoC fabric 160-2. As described more below, logic and/or circuitry of NoC UBA 120 can be arranged to route transactions to/from legacy type controllers and/or devices that are configured to use proprietary-based SoC/SoP fabric protocols such as IOSF protocols to communicate over non-NoC fabrics 160-1 or 160-2. The transactions can be routed as part of debug, survivability or infield testing of Processor 100. The legacy type controllers can include, but are not limited to a serial advanced technology attachment (SATA) controller 170, a USB controller 180, or a PCIe controller 190. Also, NoC-Bridges130-1 or 130-2 can be used to convert/translate protocols arranged to route the transactions via links to proprietary, non-NoC fabric protocols to be routed via links 163, 164 or 167. For example, NoC bridge 130-1 can translate a NoC fabric protocol used to route a transaction from NoC UBA 120 through link 114-5 to an IOSF protocol to be routed through non-NoC fabric 160-1 via link 163 to SATA controller 170 or via link 165 to USB controller 180. Also, NoC bridge 130-1 can translate a NoC fabric protocol used to route a transaction from NoC UBA 120 through link 114-7 to an IOSF protocol to be routed through non-NoC fabric 160-2 via link 167 to PCIe controller 190.

In some examples, compute cluster 155 includes a plurality of processing cores. The processing cores can be based on commercially available processors, including without limitation an AMD^{®} Zen^{®}; ARM^{®} application processor embedded and secure processors; Qualcomm^{®} Snapdragon^{®} processors; Intel^{®} Atom^{®}, Core i3, Core i5, Core i7, Xeon^{®} or Xeon Phi^{®} processors; and similar processors.

According to some examples, the various agents, controllers or compute clusters coupled to the NoC fabric 110 can be physically located on separate die or chiplets of processor 100 or at least some agents can be co-located on a same die of processor 100. For example, NoC UBA 120 can be physically located on a separate die, could be located on a portion of a die that also includes another agent, controller or compute cluster,.

In some examples, memory controller 125 can be configured to control access to volatile and/or non-volatile types of memory. The volatile and/or non-volatile types of memory can include one or more dual in-line memory modules (DIMMs). For these examples, the volatile and/or non-volatile memory can be arranged to operate in compliance with a number of memory technologies described in various standards or specifications, such as DDR3 (DDR version 3), JESD79-3F, originally released by JEDEC (Joint Electronic Device Engineering Council) in July 2012, DDR4 (DDR version 4), JESD79-4C, originally published in January 2020, DDR5 (DDR version 5), JESD79-5B originally published in September 2022, LPDDR3 (Low Power DDR version 3), JESD209-3C, originally published in August 2015, LPDDR4 (LPDDR version 4), JESD209-4D, originally published by in June 2021, LPDDR5 (LPDDR version 5), JESD209-5B, originally published by in June 2021), WIO2 (Wide Input/output version 2), JESD229-2 originally published in August 2014, HBM (High Bandwidth Memory), JESD235, originally published in October 2013, HBM2 (HBM version 2), JESD235C, originally published in January 2020, or HBM3 (HBM version 3), JESD238, originally published in January 2022, or other memory technologies or combinations of memory technologies, as well as technologies based on derivatives or extensions of such above-mentioned specifications. The JEDEC standards or specifications are available at www.jedec.org.

Although not shown in FIG. 1, processor 100 can include additional components that facilitate the operation of Processor 100. For example, internal memory devices, (e.g., caches or buffers) various network and/or internal communication interfaces and associated interconnects can communicatively couple the elements shown in FIG. 1 to each other or to elements on devices capable of being connected or attached to processor 100.

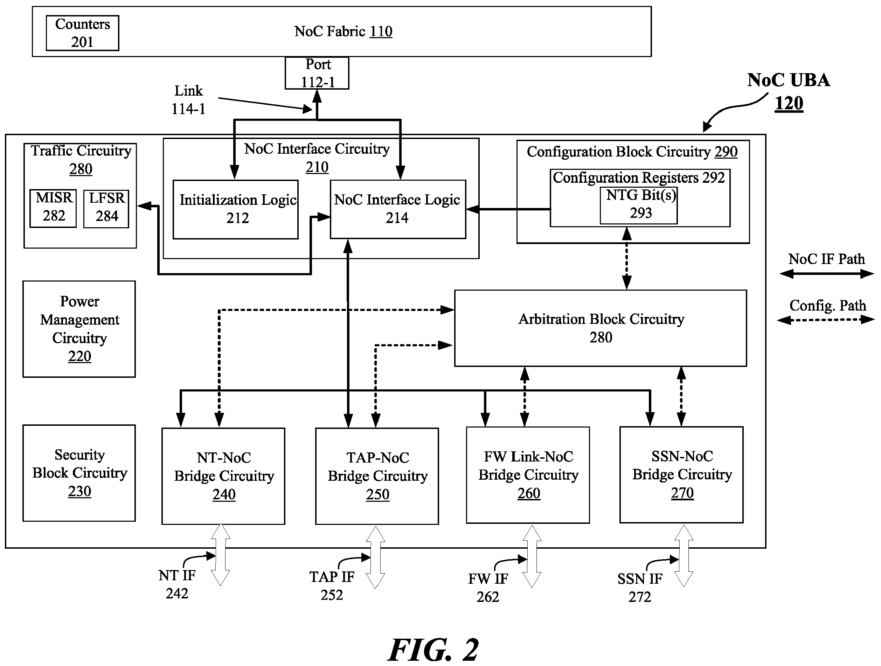

**FIG. 2** illustrates an example NoC UBA 120. In some examples, as shown in FIGS. 1 and 2, NoC UBA 120 can be coupled or connected with NoC fabric 110 through link 114-1 routed through access port 112-1. Also, as shown in FIG. 1, NoC UBA 120 can be configured to include NoC interface circuitry 210, traffic circuitry 215, power management circuitry 220, security block circuitry 230, narrow test (NT)-NoC bridge circuitry 240, test access port (TAP)-NoC bridge circuitry 250, FW link-NoC bridge circuitry 260, streaming scan network (SSN)-NoC bridge circuitry 270, arbitration block circuitry 280 or configuration block circuitry 290. The various types of circuitry mentioned above can be circuitry of a field programmable gate array (FPGA), circuitry of an application specific integrated chip (ASIC), or at least a portion of circuitry of an FPGA or an ASIC.

According to some examples, communications routed to/from logic and/or circuitry of NoC UBA 120 follow an NoC interface (IF) path shown in FIG. 2 as a solid double-arrow line. Also, configuration communications routed to/from logic and/or circuitry of NoC UBA 120 follow a configuration path shown in FIG. 2 as a dotted double-arrow line.

According to some examples, arbitration block circuitry 280 can be configured for arbitrating configuration requests received via different types of high-volume manufacturing (HVM) interfaces. These different types of HVM interfaces include NT IF 242 coupled with NT-NoC bridge circuitry 240, TAP IF 252 coupled with TAP-NoC bridge circuitry 250, FW IF 262 coupled with FW link-NoC bridge circuitry 260 or SSN IF 272 coupled with SSN-NoC bridge circuitry 270. NT IF 242, for example, can be arranged to operate as a Mobile Industry Processor Interface (MIPI^{®}) narrow interface for debug and test according to the MIPI Narrow Interface for Debug and Test (MIPI NIDnT), v1.2.1 specification, published in June 2022. TAP IF 252, for example, can be arranged to operate as an Institute of Electrical and Electronics Engineers (IEEE) 1149.1 JTAG test access port according to the IEEE 1149.1 Standard for Test Access Port and Boundary-Scan Architecture, published May 2013. FW IF 262, for example, can be arranged to enable a FW-based microcontroller to dynamically reprogram (responsive to firmware) or trigger type of synthetic context execution by NoC UBA 120. SSN IF 272, for example, can be arranged to operate as a high-speed synchronous bus to receive packetized scan test data. For these examples, NT-NoC bridge circuitry 240 can be configured to convert NT/MIPI NIDnT protocols received via NT IF 242 to a NoC protocol (e.g., non-coherent or coherent protocols such as CXL.mem, CXL.cache, CXL.io, etc..). Also, TAP-NoC bridge circuitry 250 can be configured to convert IEEE 1149.1 JTAG protocols to a NoC protocol, FW-NoC bridge circuitry 260 can be configured to convert protocols used to send information via FW IF 262 to a NoC protocol and SSN-NoC bridge circuitry 270 can be configured to convert protocols associated with receipt of packetized scan test data to a NoC protocol.

For these examples, HVM users/testers can send HVM content through one or more of NT IF 242, TAP IF 252, FW IF 262 or SSN IF 272 that follows a configuration path arbitrated by arbitration block circuitry 280 to program or set configuration registers 292 included in configuration block circuitry 290. Once programmed or set, configuration registers 292 can hold various attributes needed by NoC UBA 120 to launch one or more transactions. These attributes can include, but are not limited to, a transaction address, transaction data, transaction type (e.g., MNΠO or PCIe device configuration), a coherent transaction, or a non-coherent transaction.

In some examples, as shown in FIG. 2, configuration registers 292 can include one or more NoC transaction go (NTG) bit(s) 293. For these examples, after registers 292 have been programmed or set to include attributes needed by NoC UBA 120 to launch one or more transactions, an HVM user or tester can cause a particular NTG bit from among NTG bit(s) 293 to be set. The set NTG bit, for example, can correspond to a particular transaction to be launched. The set NTG bit from among NTG bit(s) 293 can cause NoC interface logic 214 of NoC interface circuitry 210 to send a transaction based on the attributes programmed to configuration register 292 for the particular transaction to be launched. NoC interface logic 214, for example, causes the transaction to be sent over link 114-1 to launch the transaction onto NoC fabric 110. The launched transaction can be configured to reach any agent or device coupled with NoC fabric 110 (e.g., coupled through access ports 112-2 to 112-11 and via links 114-2 to 114-11 or through non-NoC fabric 160-1/2 via links 163, 164 or 167).

According to some examples, power management circuitry 220 can be used to shut off power to NoC UBA 120. Once shut off, leakage power potentially caused when power is maintained/on for NoC UBA 120 can be saved.

In some examples, initialization logic 212 included in NoC interface circuitry 210 can be arranged to establish a connection with an agent or device through NoC fabric 110. Initialization logic 212 can also be used for exchanging credits with agents or devices to indicate how much data can be transferred through link 114-1 and/or other links based on available storage on either the side of NoC fabric 110 or at the agent or device attached to NoC fabric 110.

According to some examples, as shown in FIG. 2, traffic circuitry 215 includes a multiple input signature register (MISR) 217. For these examples, in order to improve upon scan coverage of agents or devices coupled with NoC fabric 110, responses to the NoC transactions are captured or stored by traffic circuitry 215 in MISR 217. Observations points obtained from these responses can be at least temporarily stored to MISR 217, for example, in 32-bit or 64-bit data structures. The observation points stored to MISR 217 can be used to facilitate infield debugging and/or HVM testing and can be accessed through one or more of NT IF 242, TAP IF 252, FW IF 262, or SSN IF 272. Examples are not limited to MISRs, in other examples, general purpose registers could be configured to store observation points obtained from the NoC transactions captured by traffic circuitry 215.

In some examples, as shown in FIG. 2, traffic circuitry 215 also includes a linear-feedback shift register (LFSR) 219. For these examples, random traffic is generated by LFSR 219 in association with transactions launched on NoC fabric 110 by NoC UBA 120. Generated random traffic, for example, can be used in association with programming multiple transactions in a burst and triggering burst execution to provide an effective, synthetic way to reproduce a marginal timing (voltage/frequency change) and possible intellectual property (IP)/ cross IPs race scenarios for validation or debug purposes. Traffic circuitry 215 of NoC UBA 120 can use LFSR 219 to generate, for example, traffic to include in back-to-back transactions @speed.

In some examples, security block circuitry 230 can facilitate implementation of a debug security framework. For example, security block circuitry 230 can be arranged to support Intel^{®} Debug Protection Technology to facilitate implementation of the debug security framework.

According to some examples, as shown in FIG. 2, NoC fabric 110 includes counters 201. For these examples, counters 201 can include bandwidth counters capable of being exposed to software to track data bandwidth routed through NoC fabric 110. The data bandwidth, for example, can be associated with transactions launched by NoC UBA 120 during infield debugging and/or HVM testing. In some examples, the counters can be configured as a type of performance counter such as a System on Chip Hardware Architecture Performance (SoCHAP) Counter.

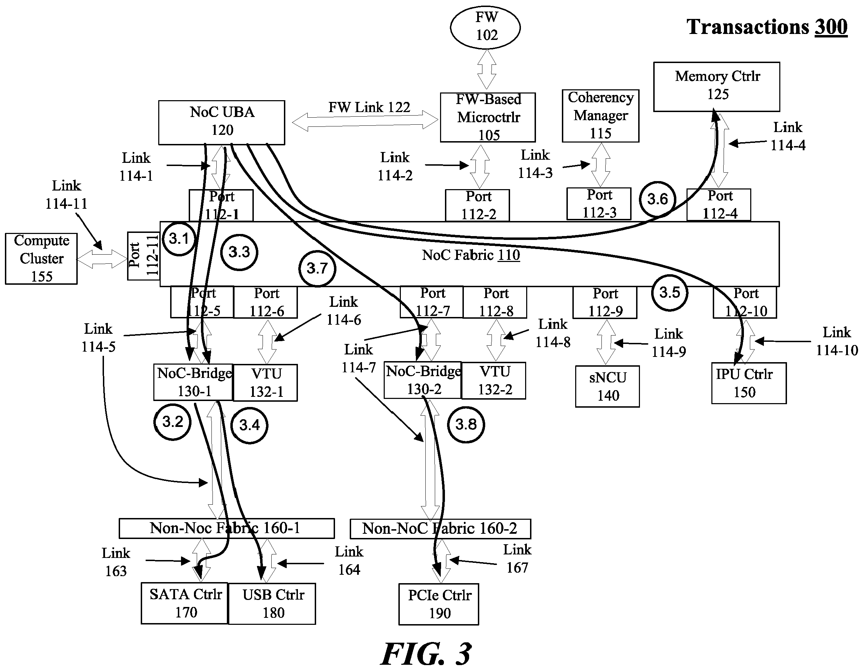

**FIG. 3** illustrates example transactions 300. In some examples, as shown in FIG. 3, transactions 300 originate from NoC UBA 120 and are routed to agents or devices directly or indirectly coupled to NoC fabric 110. For these examples, NoC UBA 120 is arranged to act as an ubiquitous debug agent that can generate or launch all types of NoC transactions to agents or devices of an SoC or SoP configured to function as a processor such as processor 100. The NoC transactions, for example, can be launched through NoC fabric 110 using various protocols such as, but not limited to, coherent or non-coherent protocols that include, but are not limited to CXL specification protocols to include CXL.mem. CXL.cache or CXL.io. These NoC transactions to be launched by NoC UBA 120 can be associated with debugging hang scenarios for processor 100, reducing silicon bring up times and improve survival mechanisms for infield operation.

According to some examples, transaction 3.1 can be a NoC transaction targeting SATA controller 170. For these examples, SATA controller 170 was arranged to couple with a non-NoC or proprietary SoC or SoP fabric such non-NoC fabric 160-1 that is arranged to use non-NoC protocols (e.g., IOSF protocols) and links. So NoC UBA 120 first routes transaction 3.1 to NoC-bridge 130-1. NoC-bridge 130-1 converts or translates the NoC transaction that initially used an NoC protocol to a non-NoC or proprietary protocol. Subsequently, NoC-bridge 130-1 generates transaction 3.2 that now uses a non-NoC or proprietary protocol to forward transaction 3.2 through non-NoC fabric 160-1. As shown in FIG. 3, transaction 3.2 is then forwarded to SATA controller 170 through non-NoC fabric 160-1 via link 163.

In some examples, transaction 3.3 can be a NoC transaction targeting USB controller 180. For these examples, USB controller 180 was also arranged to be coupled with a non-NoC or proprietary SoC or SoP fabric. So NoC UBA 120 first routes transaction 3.3 to NoC-bridge 130-1 for conversion of the NoC transaction that initially used a NoC protocol to a non-NoC protocol. Subsequently NoC-bridge 130-1 generates transaction 3.4 that now uses a non-NoC protocol to forward transaction 3.4 through non-NoC fabric 160-1. As shown in FIG. 3, transaction 3.4 is then forward to USB controller 180 through non-NoC fabric 160-1 via link 165.

According to some examples, transaction 3.5 is a direct NoC transaction to IPU controller 150. In other words, transaction 3.5 is not converted from a NoC protocol to a non-NoC protocol as IPU controller 150 is directly coupled with NoC fabric 110 and is capable of communicating using NoC protocols received through port 112-10 via link 114-10. Similarly, transaction 3.6 is also a direct NoC transaction to memory controller 125 and the NoC transaction included in transaction 3.6 can be received through port 112-4 via link 114-4

In some examples, transaction 3.7 can be a NoC transaction targeting PCIe controller 190. For these examples, PCIe controller 190 was also arranged to be coupled with non-NoC or proprietary SoC or SoP fabric. So NoC UBA 120 first routes transaction 3.7 to NoC-bridge 130-2 for conversion of the NoC transaction that initially used a NoC protocol to a non-NoC protocol. Subsequently NoC-bridge 130-2 generates transaction 3.8 that now uses a non-NoC protocol to forward transaction 3.7 through non-NoC fabric 160-2. As shown in FIG. 3, transaction 3.8 is then forward to PCIe controller 190 through non-NoC fabric 160-2 via link 167.

According to some examples, NoC transactions included in transactions 300 can include, but are not limited to, a MNΠO write, a MNΠO read, a configuration write, a configuration read, a message request, an address translation request, a page request service, a system memory write or a system memory read. In examples where NoC transactions are directed to PCIe controllers or devices, the NoC transactions can include messages formatted in compliance with the PCIe Base Specification, Rev. 6.0, published in January of 2022 by the Peripheral Component Interconnect Special Interest Group (PCI-SIG), and/or other previous or subsequent revisions ("the PCIe specification"). The PCIe controllers or devices can also be configured to operate according to the PCIe specification.

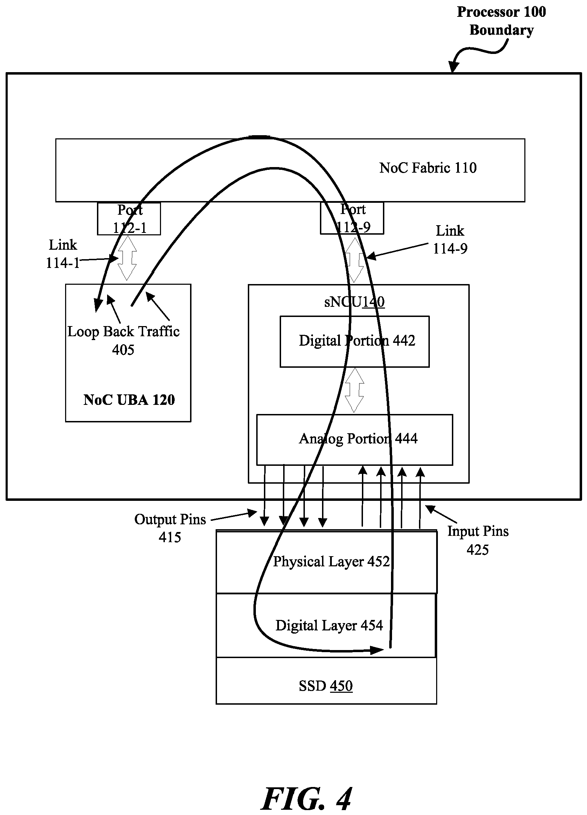

**FIG. 4** illustrates an example loop back scheme 400. According to some examples, loop back scheme 400 shows how NoC UBA 120 can execute a functional loop back test for screening defects on a boundary between an I/O digital portion and an I/O analog portion of an I/O controller and for screening defects on Processor 100's boundary. For these examples, as shown in FIG. 4, the I/O controller is sNCU 140 that includes a digital portion 442 and an analog portion 444. Also, as shown in FIG. 4, sNCU 140 is coupled with or connected to a solid state drive (SSD) 450 via output pins 415 and input pins 425 that pass through processor 100's boundary. SSD 450 is shown in FIG. 4 as including a physical layer 452 and a digital layer 454. Physical layer 452 can be arranged to included a PHY layer of a protocol stack and digital layer 454 can be arranged to include a Data Link layer and a Transaction layer of the protocol stack.

In some examples, defects on a boundary between digital portion 442 and an analog portion 444 can become manifested during infield operations involving the execution of workloads by circuitry of processor 100 and a device connected to sNCU 140 such as SSD 450 without a power off and power on event occurring for a relatively long period of time. In some deployments, such as a server in a data center, processor 100 could be included in a data center server that is not powered off for several months to years. Because of no power down for a relatively long period of time infield test are likely not to occur for processor 100. Also, boundary pins such as output pins 415 and input pins 425 between sNCU 140 and SSD 450 could also manifest defects on processor 100's boundary during these relatively long periods of operation.

According to some examples, NoC UBA 120 can generate loop back traffic associated with one or more functional tests to be performed by SSD 450. For these examples, NoC UBA 120 can cause loop back traffic 405 to be routed via link 114-1 through port 112-1 to reach NoC fabric 110 and then through port 112-9 and via link 114-9 to reach sNCU 140. Loop back traffic 405 then passes through digital portion 442 and analog portion 444 and is output to SSD 450 via output pins 415. Physical layer 452 that includes a PHY layer of a protocol stack interprets signals received via output pins 415 according to the protocol stack (e.g., a PCIe protocol stack). Digital layer 454 that includes Data Link and Transaction layers provides the data interpreted by physical layer 452 to circuitry of SSD 450 to implement one or more functional tests included in loop back traffic 405. Results of the functional tests can then be routed through input pins 425 and will loop back to NoC UBA 120 as shown in FIG 4.

According to some examples, the one or more functional tests can be targeted to detect or scan for defects at the boundary between digital portion 442 and analog portion 444. For example, incorrect protocol translation leads to a defective translation that cause incorrect signals to be output via output pins 415 that cause SSD 450 to fail the or more functional tests. The one or more functionals tests can also be targeted to detect or scan for defects at processor 100's boundary that includes output pins 415 and 425. For example, a defective output pin from among output pins 415 causes physical layer 452 to receive faulty signals, the faulty signals then cause SSD 450 to fail or not be able to perform the one or more functional tests. Also, a defective input pins from among input pins 425 can cause analog portion 444 of sNCU 140 to receive faulty signals and lead to a translated signal that can incorrectly indicate that the one or more functional tests have failed. Examples are not limited to the above-mentioned examples of targeted functional tests.

Although not shown in FIG. 4, test boundary pins between processor 100 and an external device on a motherboard can also be tested via a similar method as described above for SSD 450. For example, NoC UBA 120 can generate loop back traffic that is routed through the boundary pins between processor 100 and the external device (e.g., a DIMM coupled with memory controller 125) to test for defects in boundary pins.

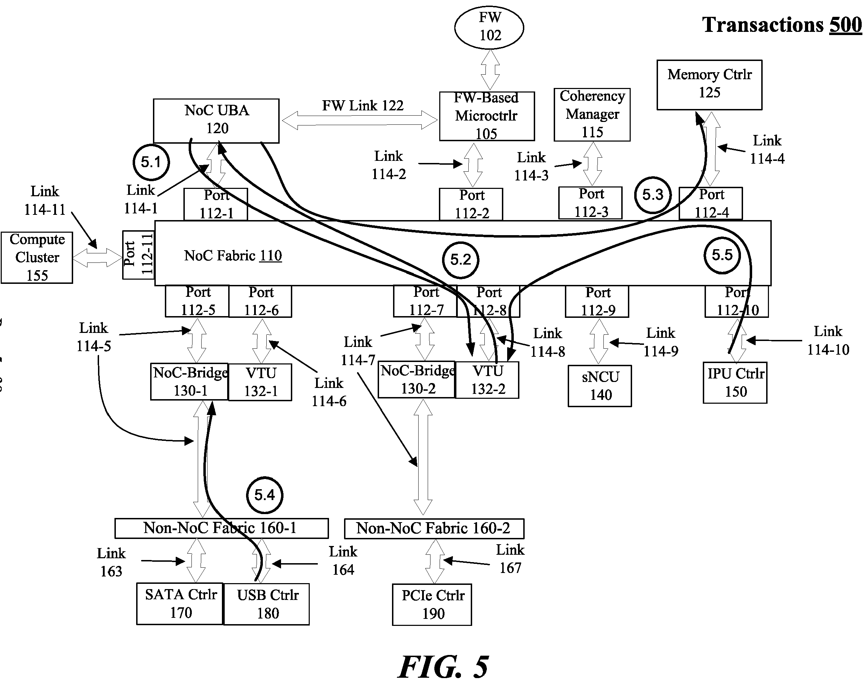

**FIG. 5** illustrates example transactions 500. As shown in FIG. 5, transactions 500 originate from NoC UBA 120, IPU controller 150 or USB controller 180. According to some examples, functional validation testing and debug activities can require an ability of NoC UBA 120 to generate various types of architecturally defined transactions to imitate real-life scenarios for deployment of an SoC or SoP configured to function as a processor such as processor 100. Imitation of flows, for example, that can be specific to integrated PCIe devices or controllers, with address translation cache (ATC) support.

According to some examples, a first imitation flow can include transaction 5.1 originating from NoC UBA 120. Transaction 5.1, for example, includes an address translation service (ATS) request to VTU 132-2. For these examples, VTU 132-2 can function as a type of input/output memory management unit (IOMMU) to perform virtual to physical memory address translations for a direct memory access (DMA) of system memory. For these examples, transaction 5.2 originating from VTU 132-2 includes a successful ATS completion message that includes a translated address that was generated in response to the ATS request. NoC UBA 120 reads the ATS completion message to obtain the translated address and then uses attribute information associated with this first imitation flow (e.g., included in configuration registers 292) to continue the first imitation flow. The first imitation flow is continued via transaction 5.3 that is routed to memory controller 125 to complete the DMA of system memory using the translated address and to store data (e.g., obtained from the attribute information associated with the first imitation flow).

In an alternative example for the first imitation flow, based on Processor 100 being configured based on a type of virtualized technology, such as Intel^{®} Virtualization Technology for Directed IO (VTd), an unsuccessful ATS response is included in transaction 5.2. For this alternative example, NoC UBA 120 can choose to issue a page request service message on the path as transaction 5.1 to VTU 132-2. The page request service message can trigger a chain of events for system agents and can eventually end with a page request group response message (e.g., as defined by the PCIe specification), sent on a same path as transaction 5.2. At this point in the alternative example for the first imitation flow, a test program or debugger can again sample received information, and determine next steps. This alternative example for the first imitation flow shows how a user of NoC UBA 120 has an ability to test various complex scenarios due to NoC UBA 120 being able to pose as any device attached or coupled to NoC fabric 110, while software can emulate a device's functionality, such as, but not limited to, ATC integration and page request service (PRS) handling logic.

According to some examples, transaction 5.4 originating from USB controller 180 shows an example of a legacy flow through non-NoC fabric 162-1 to NoC-bridge 130-2. The legacy flow for transaction 5.5, for example, can include a message signaled interrupt (MSI) or a DMA. On the other hand, transaction 5.1 shows a new path through NoC fabric 110 to VTU 132-2 that leads to a follow-on transaction 5.5 to a device or agent of IPU controller 150. These types of legacy and follow-on transactions can be tested and debugged via a holistic solution that utilizes an integrated NoC UBA 120 as described in the examples above.

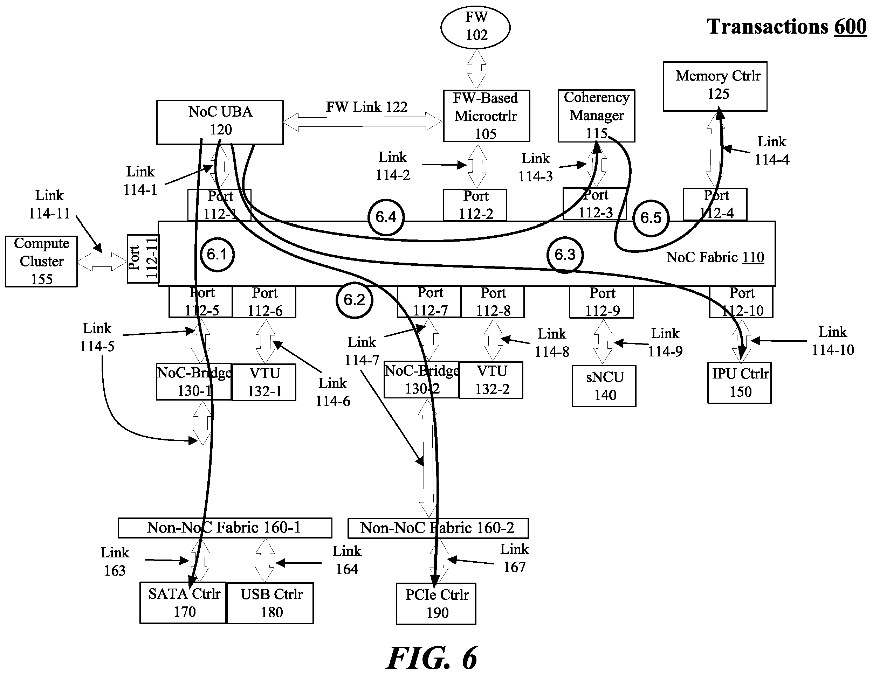

**FIG. 6** illustrates example transactions 600. As shown in FIG. 6, transactions 600 originate from NoC UBA 120 and from coherency manager 115. In some examples, a software or firmware bug in a device or agent of processor 100 can cause a miss in a step of a configuration flow for one or more devices or agents of processor 100 or cause a transaction to be incorrectly formed. The missed step or incorrectly formed transaction can result in a device, agent or system malfunction. A user or tester utilizing NoC UBA 120 can cause NoC UBA 120 to invoke configuration cycles towards, for example, a PCIe device configuration-space or a MNΠO space. Transactions 6.1, 6.2 and 6.3 can include transactions to invoke configuration cycles of SATA controller 170, PCIe controller 190 or IPU controller 150, respectively. NoC UBA 120 invoking the configuration cycles can make NoC UBA 120 appear to function as a core included in a compute cluster of processor 100 (e.g., included in compute cluster 155) in order to imitate a proper mode of work or test a work around.

According to some examples, coherency manager 115 can be configured as a NoC root complex integrated endpoint (RCiEP) according to the PCIe specification. As an RCiEP, coherency manager 115 can have a unique DMA path and can be allowed to access stolen memory regions. A stolen memory region is defined as regions of physical system memory space that are not MNΠO and are not transparent to software/BIOS. Such access can be checked based on a fabric/source decode, which can require dedicated testing. Transactions 6.4 and 6.5 can include NoC transactions to imitate a NoC RCiEP memory access by coherency manager 115 to memory controller 125 as part of a test-program or automated-debug tool using NoC UBA 120.

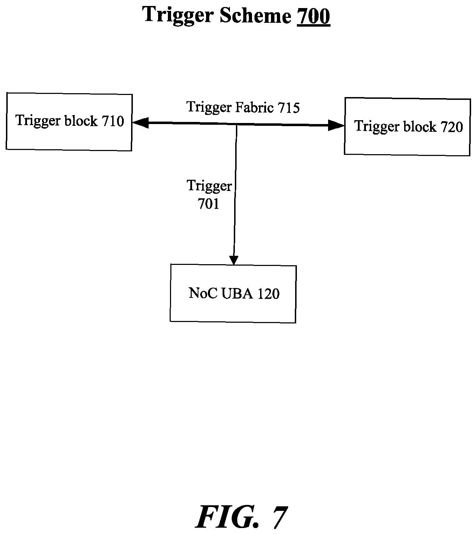

**FIG. 7** illustrates an example trigger scheme 700. In some examples, NoC UBA 120, to accurately send a transaction at a specific point in time or responsive to a specific event, is connected to a triggering system that includes trigger block 710 and trigger block 720 and trigger fabric 715. Trigger block 710, for example, can include a point in time trigger (e.g., every 24 hours). Trigger block 720, for example, can include one or more trigger events. In some examples, NoC UBA 120 can use FW link 122 with FW-based microcontroller 105 (see FIG. 6) to connect to triggering fabric 715. A debug software tool or debug firmware tool (e.g., included in FW 102 - see FIG. 6) can configure a message for NoC UBA 120 to use when a transaction is triggered by trigger 701. Trigger scheme 700 can be useful to debug, generate some stress, or for injecting a command for survivability at a specific point in time. Trigger scheme 700 can cause trigger 701 responsive to an internal event of processor 100 such as, but not limited to, an internal bus transaction, a finite-state machine (FSM) state, or an internal counter value (e.g., maintained in counters 201). Trigger 701 can also occur on a point in time such as hourly, daily, weekly, etc.. points of time.

Included herein is a logic flow representative of example methodologies for performing novel aspects of the disclosed techniques for a data-aware cache replacement. While, for purposes of simplicity of explanation, the one or more methodologies shown herein are shown and described as a series of acts, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, and/or hardware. In software and firmware examples, a logic flow can be implemented by computer executable instructions stored on at least one non-transitory computer readable medium or machine readable medium, such as an optical, magnetic or semiconductor storage. The examples are not limited in this context.

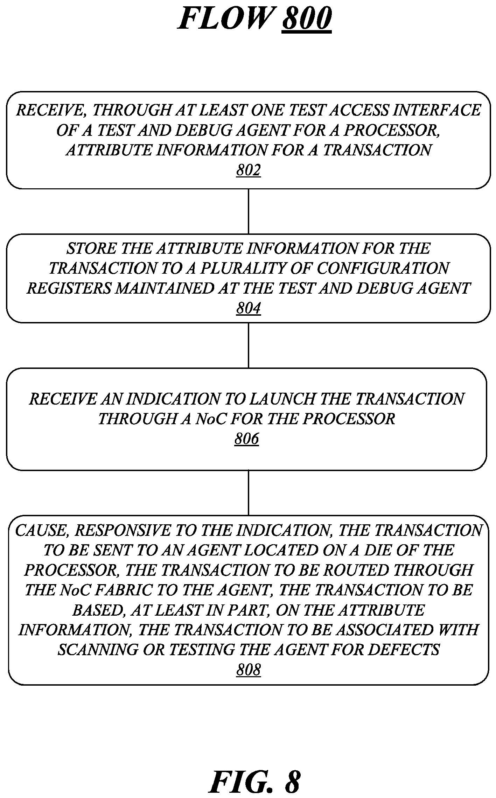

**FIG. 8** illustrates an example flow 800. According to some examples, flow 800 can be an example of actions taken by a test and debug agent for a processor such as NoC UBA 120 for processor 100 as described above for FIGS. 1-7.

In some examples, as shown in FIG. 8, logic flow 800 at 802 can receive, through at least one test access interface of a test and debug agent for a processor, attribute information for a transaction. For these examples, the at least one test access interface can include NT IF 242, TAP IF 252, FW IF 262 and SSN IF 272 as shown in FIG. 2 and described above.

According to some examples, logic flow at 804 can store the attribute information for the transaction to a plurality of configuration registers maintained at the test and debug agent. For these examples, the attribute information can be stored to configuration registers 292 maintained at NoC UBA 120 as shown in FIG. 2.

In some examples, logic flow at 806 can receive an indication to launch the transaction through an NoC fabric for the Processor. For these examples, the indication can be based on a trigger or setting of a bit included in a configuration register of configuration registers 292 (e.g., NTG bit(s) 293).

According to some examples, logic flow at 808 can cause, responsive to the indication, the transaction to be sent to an agent located on a die of the processor, the transaction to be routed through the NoC fabric to the agent, the transaction to be based, at least in part, on the attribute information, the transaction to be associated with scanning or testing the agent for defects. For these examples, the agent can be, but is not limited to, coherency manager 115, memory controller 125, IPU controller 150, sNCU 140, SATA controller 170, USB controller 180 or PCIe controller 190. The transaction can include, but is not limited to a MNΠO write to the agent, a MNΠO read to the agent, a configuration write request to the agent, a configuration read request to the agent, a message request to the agent, an address translation request to the agent or a page request service to the agent.

References to "one example," "an example," etc., indicate that the example described may include a particular feature, structure, or characteristic, but every example may not necessarily include the particular feature, structure, or characteristic. Moreover, such phrases are not necessarily referring to the same example. Further, when a particular feature, structure, or characteristic is described in connection with an example, it is submitted that it is within the knowledge of one skilled in the art to affect such feature, structure, or characteristic in connection with other examples whether or not explicitly described.

Moreover, in the various examples described above, unless specifically noted otherwise, disjunctive language such as the phrase "at least one of A, B, or C" or "A, B, and/or C" is intended to be understood to mean either A, B, or C, or any combination thereof (i.e. A and B, A and C, B and C, and A, B and C).

The specification and drawings are, accordingly, to be regarded in an illustrative rather than a restrictive sense. It will, however, be evident that various modifications and changes may be made thereunto without departing from the broader spirit and scope of the disclosure as set forth in the claims.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

The following examples pertain to additional examples of technologies disclosed herein.

An example apparatus can include a NoC interface configured to couple with an NoC fabric for a processor, at least one test access interface, a plurality of configuration registers, and circuitry. The circuitry can be configured to receive, through the at least one test access interface, attribute information for a transaction. The circuitry can also be configured to cause the attribute information for the transaction to be stored to the plurality of configuration registers. The circuitry can also be configured to receive an indication to launch the transaction onto the NoC fabric. The circuitry can also be configured to cause, responsive to the indication, the transaction to be sent to an agent located on a die of the processor, the transaction to be routed through the NoC fabric to the agent, the transaction to be based, at least in part, on the attribute information, the transaction to be associated with scanning or testing the agent for defects.

In the example apparatus, the transaction can include a MNΠO write to the agent, a MNΠO read to the agent, a configuration write request to the agent, a configuration read request to the agent, a message request to the agent, an address translation request to the agent or a page request service to the agent.

The example apparatus can also include one or more MISRs. For this example, the circuitry can also be configured to receive response information from the agent that is associated with the transaction and cause the response information to be stored to the one or more MISRs.

In the example apparatus, the indication to launch the transaction can be based on a bit to be set in a configuration register included in the plurality of configuration registers, the bit to correspond to the transaction.

In the example apparatus, the indication to launch the transaction can be responsive to a trigger that is based on an event or a point in time.

In the example apparatus, the agent to receive the transaction can be connected to a device that is external to the processor. Optionally, the transaction can be associated with scanning or testing the agent for defects is to scan or test a digital to analog boundary at the agent and scan, test pins used to connect the device to the agent, or test boundary pins between the processor and an external device on a motherboard.

In the example apparatus, the at least one test interface can be a narrow test interface, a test access port interface, a streaming scan network interface, or a firmware interface. Optionally, the narrow test interface can be configured to operate as a MIPI narrow interface for debug and test or the test access port interface can be configured to operate as an IEEE 1149.9 JTAG interface.

In the example apparatus, the attribute information can be received from a user or tester of a high volume manufacturer of the processor.

In the example apparatus, the at least one test interface can be a FW interface to be coupled with a FW-based microcontroller at the processor, the attribute information can be received from the FW-based microcontroller responsive to executable code included in FW maintained at the processor.

In the example apparatus, the apparatus can be located on a first die of the Processor and the agent can be located on a second die of the processor.

In the example apparatus, the processor can be an SoC or an SoP.

An example method can include receiving, through at least one test access interface of a test and debug agent for a processor, attribute information for a transaction. The method can also include storing the attribute information for the transaction to a plurality of configuration registers maintained at the test and debug agent. The method can also include receiving an indication to launch the transaction through NoC fabric for the processor. The method can also include causing, responsive to the indication, the transaction to be sent to an agent located on a die of the processor, the transaction to be routed through the NoC fabric to the agent, the transaction to be based, at least in part, on the attribute information, the transaction to be associated with scanning or testing the agent for defects.

In the example method, the transaction can include a MNΠO write to the agent, a MNΠO read to the agent, a configuration write request to the agent, a configuration read request to the agent, a message request to the agent, an address translation request to the agent or a page request service to the agent.

The example method can also include receiving response information from the agent that is associated with the transaction. The method can also include causing the response information to be stored to one or more general purpose registers maintained with the test and debug agent.

In the example method, the indication to launch the transaction can be based on a bit to be set in a configuration register included in the plurality of configuration registers, the bit to correspond to the transaction.

In the example method, the indication to launch the transaction can be responsive to a trigger that is based on an event or a point in time.

In the example method, the agent to receive the transaction can be connected to a device that is external to the processor. Optionally, the transaction to be associated with scanning or testing the agent for defects can be to scan or test a digital to analog boundary at the agent and scan test pins used to connect the device to the agent, or test boundary pins between the processor and an external device on a motherboard.

In the example method, the at least one test interface can be a narrow test interface, a test access port interface, a streaming scan network interface, or a firmware interface. Optionally, the narrow test interface can be configured to operate as a MIPI narrow interface for debug and test or the test access port interface can be configured to operate as an IEEE 1149.9 JTAG interface.

In the example method, the attribute information can be received from a user or tester of a high volume manufacturer of the processor.

In the example method, the at least one test interface can be a FW interface to be coupled with a FW-based microcontroller at the processor, the attribute information can be received from the FW-based microcontroller responsive to executable code included in FW maintained at the processor.

In the example method, the test and debug agent can be located on a first die of the processor and the agent can be located on a second die of the processor.

An example at least one machine readable medium can include a plurality of instructions that in response to being executed by a system can cause the system to carry out a method according to any one of example methods.

An example apparatus can include means for performing the methods of any one of example methods.

An example at least one machine readable medium can include a plurality of instructions that in response to being executed by a test and debug agent for a processor, can cause the test and debug agent to receive, through at least one test access interface of the test and debug agent, attribute information for a transaction. The instructions can also cause the test and debug agent to store the attribute information for the transaction to a plurality of configuration registers maintained at the test and debug agent. The instructions can also cause the test and debug agent to receive an indication to launch the transaction through NoC fabric for the processor. The instructions can also cause the test and debug agent to cause, responsive to the indication, the transaction to be sent to an agent located on a die of the processor, the transaction to be routed through the NoC fabric to the agent, the transaction to be based, at least in part, on the attribute information, the transaction to be associated with scanning or testing the agent for defects.

In the example at least one machine readable medium, the transaction can include a memory-mapped input/out (MMIO) write to the agent, a MNΠO read to the agent, a configuration write request to the agent, a configuration read request to the agent, a message request to the agent, an address translation request to the agent or a page request service to the agent.

In the example at least one machine readable medium, the instructions can further cause the test and debug agent to receive response information from the agent that is associated with the transaction. The instructions can also cause the test and debug agent to cause the response information to be stored to one or more MISRs maintained with the test and debug agent.

In the example at least one machine readable medium, the indication to launch the transaction can be based on a bit to be set in a configuration register included in the plurality of configuration registers, the bit to correspond to the transaction.

In the example at least one machine readable medium, the indication to launch the transaction can be responsive to a trigger that is based on an event or a point in time.

In the example at least one machine readable medium, the agent to receive the transaction can be connected to a device that is external to the processor. Optionally, the transaction to be associated with scanning or testing the agent for defects can be to scan test a digital to analog boundary at the agent and scan or test pins used to connect the device to the agent, or test boundary pins between the processor and an external device on a motherboard.

In the example at least one machine readable medium, the at least one test interface can be a narrow test interface, a test access port interface, a streaming scan network interface, or a firmware interface. Optionally, the narrow test interface can be configured to operate as a MIPI narrow interface for debug and test or the test access port interface can be configured to operate as an IEEE 1149.9 JTAG interface.

In the example at least one machine readable medium, the attribute information can be received from a user or tester of a high volume manufacturer of the processor.

In the example at least one machine readable medium, the at least one test interface can be a FW interface to be coupled with a FW-based microcontroller at the processor, the attribute information can be received from the FW-based microcontroller responsive to executable code included in FW maintained at the processor.

In the example at least one machine readable medium, the test and debug agent can be located on a first die of the processor and the agent is located on a second die of the processor.

It is emphasized that the Abstract of the Disclosure is provided to comply with 37 C.F.R. Section 1.72(b), requiring an abstract that will allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in a single example for the purpose of streamlining the disclosure. This method of disclosure is not to be interpreted as reflecting an intention that the claimed examples require more features than are expressly recited in each claim. Rather, as the following claims reflect, inventive subject matter lies in less than all features of a single disclosed example. Thus, the following claims are hereby incorporated into the Detailed Description, with each claim standing on its own as a separate example. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. An apparatus comprising:
an interface configured to couple with a system fabric for a system-on-chip, SoC;
a first test access interface;
a second test access interface
a plurality of configuration registers; and
circuitry configured to:
receive, concurrently, first attribute information for a first transaction through the first test access interface and second attribute information for a second transaction through the second test access interface;
store the first and the second attribute information for the first and second transactions to the plurality of configuration registers;
receive a first indication to launch the first transaction;
receive a second indication to launch the second transaction; and
cause, responsive to the first and second indications, the first transaction to be sent to a memory agent located on the SoC and the second transaction to be sent to an input/output, I/O, agent located on the SoC, the first transaction to be routed through the system fabric to the memory agent and the second transaction to be routed through the system fabric to the I/O agent, the first and second transactions to be associated with concurrently scanning or testing the memory agent and the I/O agent for defects.

2. The apparatus of claim 1, wherein the first transaction includes a memory-mapped input/out, MNΠO, write to the memory agent, a MNΠO read to the memory agent, or a configuration write request to the memory agent and the second transaction includes a configuration read request to the I/O agent, a message request to the I/O agent, an address translation request to the I/O agent or a page request service to the I/O agent.

3. The apparatus of claim 1 or 2, further comprising:
one or more multiple input signature registers, MISRs,
wherein the circuitry is configured to:
receive first response information from the memory agent generated based on the first transaction;
receive second response information from the I/O agent generated based on the second transaction; and
cause the first and second response information to be stored to the one or more MISRs.

4. The apparatus of any one of claims 1-3, wherein the first indication to launch the first transaction is based on at least one bit to be set in a first configuration register included in the plurality of configuration registers, and the second indication to launch the second transaction is based on at least one bit to be sent in a second configuration register included in the plurality of configuration registers.

5. The apparatus of any one of claims 1-4, wherein the first or the second indication to launch the first or the second transaction is responsive to at least one trigger that is based on an event or a point in time.

6. The apparatus of any one of claims 1-5, wherein the first and second attribute information is to be received from a user or tester of a high volume manufacturer of the SoC.

7. The apparatus of any one of claims 1-6, wherein the first test access interface comprises a test access port interface to be configured to operate as an IEEE 1149.9 JTAG interface and the second test access interface is a narrow test interface configured to operate as a MIPI narrow interface for debug and test.

8. A method implemented by a test and debug agent for a system-on-chip, SoC, the method comprising:
receiving, concurrently, first attribute information for a first transaction through a first test access interface of the test and debug agent and second attribute information for a second transaction through a second test access interface of the test and debug agent;
storing the first and the second attribute information for the first and second transactions to a plurality of configuration registers maintained at the test and debug agent;
receiving a first indication to launch the first transaction;
receiving a second indication to launch the second transaction; and
causing, responsive to the first and second indications, the first transaction to be sent to a memory agent located on the SoC and the second transaction to be sent to an input/output, I/O agent located on the SoC, the first transaction to be routed through a system fabric for the SoC to the memory agent and the second transaction to be routed through the system fabric to the I/O agent, the first and second transactions to be associated with concurrently scanning or testing the memory agent and the I/O agent for defects.

9. The method of claim 8, wherein the first transaction includes a memory-mapped input/out, MNΠO, write to the memory agent, a MNΠO read to the memory agent, or a configuration write request to the memory agent and the second transaction includes a configuration read request to the I/O agent, a message request to the I/O agent, an address translation request to the I/O agent or a page request service to the I/O agent.

10. The method of claim 8 or 9, further:
receiving first response information from the memory agent generated based on the first transaction;
receiving second response information from the I/O agent generated based on the second transaction; and
causing the first and second response information to be stored to one or more multiple input signature registers, MISRs, maintained with the test and debug agent.

11. The method of any one of claims 8-10, wherein the first indication to launch the first transaction is based on at least one bit to be set in a first configuration register included in the plurality of configuration registers, and the second indication to launch the second transaction is based on at least one bit to be sent in a second configuration register included in the plurality of configuration registers.

12. The method of any one of claims 8-11, wherein the first or the second indication to launch the first or the second transaction is responsive to at least one trigger that is based on an event or a point in time.

13. The method of any one of claims 8-12, wherein the first and second attribute information is received from a user or tester of a high volume manufacturer of the SoC.

14. The method of any one of claims 8-13, wherein the first test access interface comprises a test access port interface configured to operate as an IEEE 1149.9 JTAG interface and the second test access interface is a narrow test interface configured to operate as a MIPI narrow interface for debug and test.

15. At least one machine readable medium comprising a plurality of instructions that in response to being executed by a test and debug agent for a system-on-chip, SoC, causes the test and debug agent to perform the method of any one of claims 8-14.
